# DEMANDE DE BREVET EUROPEEN

(11) **EP 3 260 932 A1**
(43) Date de publication de la demande: **27.12.2017**
(21) Numéro de dépôt: 16175797.6
(22) Date de dépôt: 22.06.2016
(51) Int. Cl.: G04D 3/00, B28B 1/16, C04B 35/563, C04B 35/58, G03F 7/20

(54) **PROCÉDÉ DE FABRICATION D'UN COMPOSANT HORLOGER EN CÉRAMIQUE**

(71) Demandeur: Nivarox-FAR S.A., 2400 Le Locle (CH)
(72) Inventeur: Dubois, Philippe, 2074 Marin (CH); Salihu, Fatmir, 2000 Neuchâtel (CH)
(74) Mandataire: Goulette, Ludivine

(57) **Abrégé**

Fabrication d'un composant horloger en céramique obtenu par remplissage d'un moule structuré par photolithographie d'un matériau précurseur de la céramique souhaitée.

## Description

### Domaine de l'invention

L'invention se rapporte à un procédé de fabrication d'un composant horloger en céramique et plus précisément à base de céramique polycristalline.

### Arrière-plan de l'invention

Dans le domaine de l'horlogerie, il est connu de former des pièces de l'habillage en céramique polycristalline à l'aide d'un moulage par injection (également connu sous l'abréviation anglaise « CIM »). Ainsi, une matière, généralement appelée « feedstock », est injectée dans un moule sous pression puis des étapes de déliantage et de frittage sont réalisées pour obtenir la pièce en céramique polycristalline avec une grande cadence.

Toutefois, l'étape d'injection génère des lignes de jonctions des fronts de la matière injectée qui oblige à une étape de retouche ainsi qu'à une fragilité mécanique localisée à ces jonctions. Il est également nécessaire de retirer les surplus de matière au niveau des zones d'injection.

Enfin, le moulage par injection est difficilement applicable à la fabrication de pièces de faible épaisseur typiquement inférieure à 1 millimètre à cause de la difficulté à injecter la matière par des canaux fins mais également par la difficulté à démouler et à rectifier les pièces sans bris.

### Résumé de l'invention

Le but de la présente invention est de pallier tout ou partie les inconvénients cités précédemment en proposant un procédé de fabrication capable de former sans retouche un composant horloger en céramique polycristalline de faible épaisseur, sans défaut de planéité et avec une grande précision dimensionnelle.

A cet effet, selon un premier mode de réalisation, l'invention se rapporte à un procédé de fabrication d'un composant horloger en céramique comportant les étapes suivantes :
- former, par photolithographie sur un substrat, un moule muni d'au moins une cavité ;
- remplir ladite au moins une cavité du moule à l'aide d'un matériau précurseur d'une céramique ;
- retirer le moule pour libérer une ébauche en matériau précurseur ;
- transformer l'ébauche en matériau précurseur en composant horloger en céramique ;
- libérer le composant horloger en céramique du substrat.

De plus, selon un deuxième mode de réalisation, l'invention se rapporte à un procédé de fabrication d'un composant horloger en céramique comportant les étapes suivantes :
- former, par photolithographie sur un substrat, un moule muni d'au moins une cavité ;
- remplir ladite au moins une cavité du moule à l'aide d'un matériau précurseur d'une céramique ;
- retirer le moule pour libérer une ébauche en matériau précurseur ;
- libérer l'ébauche en matériau précurseur du substrat ;
- transformer l'ébauche en matériau précurseur en composant horloger en céramique.

Conformément à d'autres variantes avantageuses de l'invention :
- le moule est formé à partir d'une résine photosensible du type positif ou négatif ;
- ladite au moins une cavité du moule comporte au moins une paroi non verticale ;
- le moule comporte plusieurs cavités ;
- deux cavités de motifs différents sont formées l'une au-dessus de l'autre concentriquement pour former un composant horloger à plusieurs niveaux ;
- au moins deux cavités adjacentes sont reliées par un canal pour former une plaquette avec plusieurs composants horlogers reliés entre eux ;
- le substrat est formé à base de silicium ou de céramique ;
- l'étape de remplissage est réalisée par voie liquide ;
- l'étape de remplissage comporte les phases suivantes ; couler une barbotine dans le moule et sécher la barbotine afin d'obtenir le matériau précurseur d'une céramique dans le moule ;
- la barbotine comporte une matière liquide, de la poudre de céramique et au moins un adjuvant destiné à faciliter le procédé ;
- la matière liquide comporte de l'eau ou un solvant ;
- la poudre de céramique comporte une taille de grains inférieure à 10 *µ*m ;
- la poudre de céramique comporte du bore pour améliorer la tribologie du composant horloger ;
- ledit au moins un adjuvant comporte un liant permettant à l'ébauche en matériau précurseur à former une masse homogène à l'issue de la phase de séchage ;
- ledit au moins un adjuvant comporte un dispersant permettant à la barbotine de former une suspension homogène lors de la phase de coulage ;
- l'étape de retrait du moule comporte une attaque sèche, une attaque humide ou un traitement thermique ;
- le procédé comporte en outre, avant l'étape de remplissage du moule, une étape de dépôt d'une couche anti-adhérente permettant de retirer plus facilement le substrat ;
- le procédé comporte en outre, après l'étape de formation du moule, une étape de mise en épaisseur du moule afin d'homogénéiser son épaisseur ;
- le procédé comporte en outre, avant l'étape de retrait du moule, une étape de mise en épaisseur du moule et de l'ébauche en matériau précurseur afin d'ajuster l'état de surface et l'épaisseur de l'ébauche en matériau précurseur ;
- le composant horloger forme tout ou partie d'une pièce d'habillage ou d'un organe du mouvement d'une pièce d'horlogerie.

### Description sommaire des dessins

D'autres particularités et avantages ressortiront clairement de la description qui en est faite ci-après, à titre indicatif et nullement limitatif, en référence aux dessins annexés, dans lesquels :
- les figures 1 à 4 sont des représentations d'étapes successives du procédé selon l'invention ;
- les figures 5 à 10 sont des représentations de composants horlogers selon l'invention ;
- les figures 11 et 12 sont des représentations d'étapes successives du procédé selon une alternative de l'invention ;
- les figures 13 et 14 sont des représentations de composants horlogers selon une alternative de l'invention.

### Description détaillée des modes de réalisation préférés

Le composant selon l'invention a été imaginé pour des applications dans le domaine horloger et est rendu nécessaire par la part croissante que tiennent les matériaux fragiles comme ceux à base de céramique. Les composants horlogers ont la caractéristique d'avoir une épaisseur très faible par rapport à leur surface principale en projection. Ainsi, une surface principale en projection peut typiquement comporter une longueur ponctuelle ou un diamètre compris entre 2 et 6 millimètres qui est élevé au regard de l'épaisseur comprise entre 10 à 400 *µ*m.

C'est pourquoi, l'invention se rapporte à un procédé de fabrication capable de former sans retouche un composant horloger en céramique polycristalline de faible épaisseur, sans défaut de planéité et avec une grande précision dimensionnelle. En effet, les retouches sur de si faible épaisseur de céramique est très difficile à réaliser sans occasionner des bris ou égrisures sur la céramique.

On comprend donc que le composant horloger peut former tout ou partie d'une pièce d'habillage ou d'un organe du mouvement d'une pièce d'horlogerie. On peut, à titre d'exemple, envisager de former le spiral, le balancier, l'ancre, les ponts, la masse oscillante ou même les mobiles comme les roues d'échappement totalement ou partiellement à base de céramique. Il est également envisageable de former un boîtier, un cadran, un affichage, un décor, un index, une applique, un réhaut, une lunette, un poussoir, une couronne, un fond de boîtier, une aiguille ou un bracelet totalement ou partiellement à base de céramique selon l'invention.

Afin de garantir la planéité et la précision dimensionnelle, l'invention se rapporte à un procédé de fabrication utilisant le remplissage d'un moule structuré par photolithographie d'un matériau précurseur de la céramique souhaitée. En effet, comme expliqué ci-dessous, le recours à la photolithographie apporte une très grande précision dimensionnelle au composant horloger en céramique.

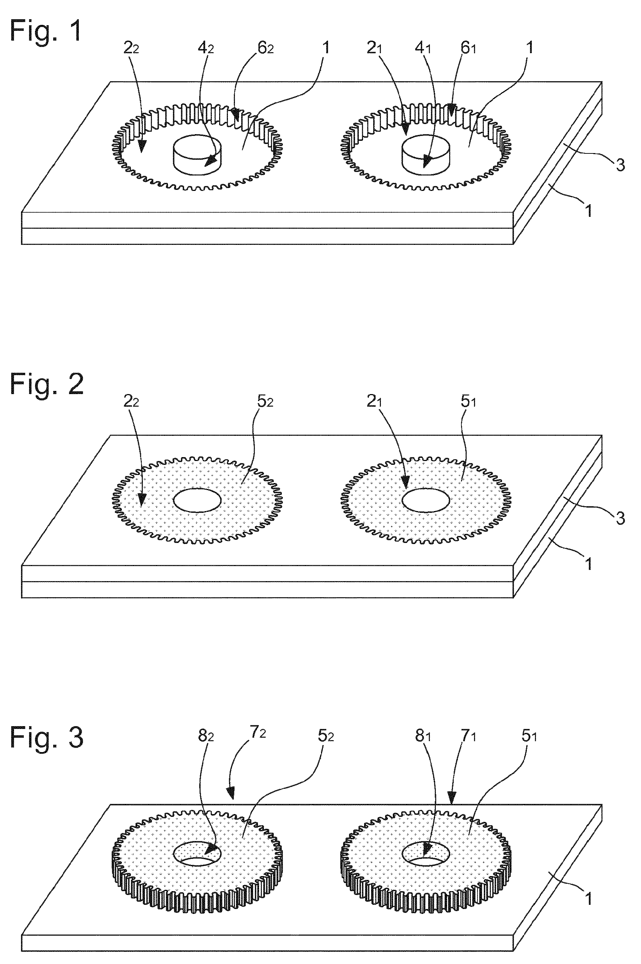

Le procédé de fabrication du composant horloger en céramique comporte une première étape destinée à former, par photolithographie sur un substrat 1, un moule 3 muni d'au moins une cavité 2₁, 2₂ comme illustré à la figure 1. La photolithographie étant un processus connu en soit, il ne sera pas d'avantage expliqué ci-dessous.

Le moule 3 peut être formé indifféremment à partir d'une résine photosensible du type positif ou négatif. Dans le cadre du développement, une résine photosensible négative du type SU-8 a été utilisée pour sa facilité de structuration, son faible coût et sa capacité à former des couches jusqu'à 500 *µ*m.

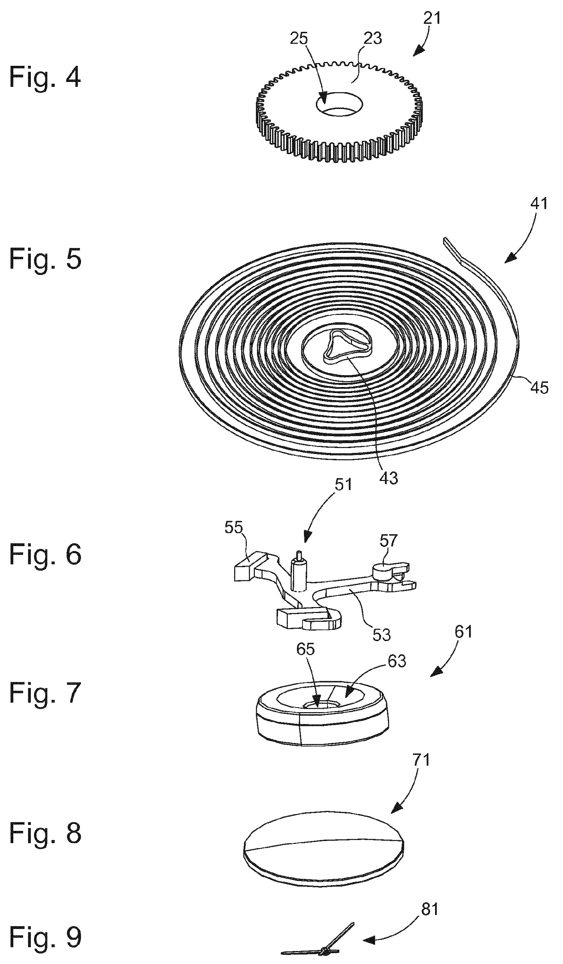

Comme visible à la figure 1, une ou plusieurs cavités 2₁, 2₂ peut être structurée à la surface du substrat 1. Si plusieurs cavités 2₁, 2₂ sont structurées, elles peuvent être de motifs identiques ou différents. On peut également voir, à titre d'exemple à la figure 1, des cavités 2₁, 2₂ chacune de forme annulaire avec une paroi distale 6₁, 6₂ sensiblement verticale et dentée et une paroi proximale 4₁, 4₂ sensiblement verticale. On comprend donc que le composant horloger 21 qui sera formé, sera une roue dentée 23 munie d'un évidement central 25 comme illustré à la figure 4.

Bien évidemment, le processus de cette première étape peut être adapté suivant les formes de composant souhaitées. Ainsi, de manière non limitative, la photolithographie peut être du type stéréolithographie (également connu sous l'abréviation anglaise « SLA »), du type sans masque (également connu sous l'abréviation anglaise « MLA ») ou du type à masque à variation de transmittance (également connu sous l'expression anglaise « gray scale lithography »).

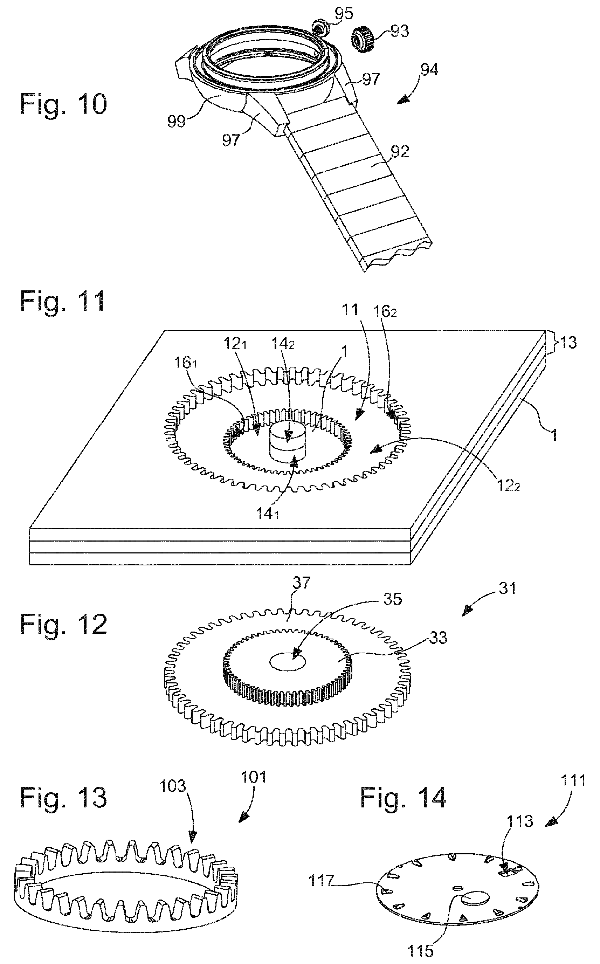

En effet, à titre d'exemple, une photolithographie du type à masque à variation de transmittance permet à ladite au moins une cavité 2₁, 2₂ du moule 3 de comporter au moins une paroi non verticale pour obtenir par exemple un composant du type de la figure 13 comme expliqué ci-dessous.

De plus, la première étape ne saurait se limiter à un moule 3 avec un seul motif par cavité 2₁, 2₂. La première étape pourrait également former un moule à plusieurs niveaux c'est-à-dire qu'au moins deux cavités de motifs différents soient formées concentriquement l'une au-dessus de l'autre pour former un composant horloger à plusieurs niveaux.

Selon une alternative illustrée à la figure 11, on peut voir un moule 13 avec une empreinte 11 comportant une cavité inférieure 12₁ de forme annulaire avec une paroi distale 16₁ sensiblement verticale et dentée et une paroi proximale 14₁ sensiblement verticale, et une cavité supérieure 12₂, plus large et concentrique par rapport à la cavité inférieure 12₁, de forme annulaire avec une paroi distale 16₂ sensiblement verticale et dentée et une paroi proximale 14₂ sensiblement verticale. On comprend donc que le composant horloger 31 qui sera formé, sera une double roue dentée 33, 37 monobloc qui est munie d'un évidement central 35 comme illustré à la figure 12. A titre d'exemple, un tel moule 13 peut être obtenu par plusieurs photolithographies successives lors de la première étape.

Il est également parfaitement envisageable qu'au moins deux cavités adjacentes soient reliées par un canal pour former une plaquette avec plusieurs composants horlogers reliés entre eux. On permettrait alors une manipulation en plaquette à la manière d'une plaquette de silicium après gravage de composants.

Dans les exemples des figures 1 et 11, le substrat 1 forme le fond des cavités 2₁, 2₂, 12₁. Par conséquent, le substrat 1 peut être formé à base de silicium ou de céramique suivant le mode de réalisation expliqué ci-dessous. Toutefois, le fond pourrait alternativement être formé par une couche du moule 3, 13.

Quelle que soit la manière de former le fond des cavités, il apparaît immédiatement que son état de surface peut être avantageusement choisi afin de définir l'aspect de la face correspondante du composant horloger. A titre d'exemples, le fond des cavités pourrait avoir une structuration en surface agencée pour former un décor sur la face correspondante du composant horloger ou, au contraire, une surface polie donnant un aspect poli miroir à la face correspondante du composant horloger.

Optionnellement, le procédé peut comporter après la première étape de formation du moule 3 ou entre chaque photolithographie du moule 13, une étape de mise en épaisseur du moule 3, 13 afin d'homogénéiser l'épaisseur du moule 3 ou au moins une des épaisseurs du moule 13.

De plus, avant le début de la deuxième étape expliquée ci-dessous, le procédé peut, de manière optionnelle, comporter une étape de dépôt d'une couche anti-adhérente permettant de libérer plus facilement l'ébauche en matériau précurseur et/ou du composant horloger en céramique à la fin du procédé. Une telle couche pourrait être déposée sur la totalité de la surface supérieure du moule 3, 13 ou uniquement sur une partie du moule 3, 13 comme par exemple uniquement dans les cavités 2₁, 2₂, 12₁, 12₂ ou uniquement sur le fond des cavités 2₁, 2₂, 12₁. Une telle couche anti-adhérente pourrait, par exemple, être une fine couche de poudre de nitrure de bore. Avantageusement selon l'invention, une telle couche autorise une libération facilitée mais également de compensation du retrait de la céramique lors de l'étape de frittage expliquée ci-dessous.

La deuxième étape du procédé est destinée à remplir ladite au moins une cavité 2₁, 2₂, 12₁, 12₂ du moule 3, 13 à l'aide d'un matériau précurseur d'une céramique. Préférentiellement selon l'invention, l'étape de remplissage est réalisée par voie liquide.

Ainsi, selon un exemple préféré, l'étape de remplissage comporte une première phase destinée à couler une barbotine dans le moule 3, 13 suivie, éventuellement, d'un raclage destiné à retirer le surplus de barbotine. Selon l'invention, la barbotine peut comporter une matière liquide, de la poudre de céramique et au moins un adjuvant destiné à faciliter le procédé. La matière liquide peut comporter de l'eau préférentiellement déionisée ou un solvant.

La poudre de céramique peut comporter une grande variété de matériaux grâce à la voie liquide choisie. Un oxyde, carbure ou nitrure de métal comme, par exemple, une zircone ou une alumine peut être utilisée. Bien entendu, le mélange de plusieurs poudres de natures différentes peut également être envisagé. Il est également apparu qu'une taille de grains inférieure à 10 *µ*m était souhaitable par rapport aux dimensions finales souhaitées et notamment la faible épaisseur indiquée ci-dessus.

Dans le but notamment de fabriquer des composants horlogers capables de transmettre des forces et d'avoir un faible coefficient de frottement, il est apparu qu'une poudre de céramique à base de bore, comme, par exemple, du carbure de bore (B₄C) ou du diborure de titane (TiB₂), était particulièrement intéressante.

A titre d'exemple, ledit au moins un adjuvant de la barbotine peut comporter un dispersant permettant à la barbotine de former une suspension homogène notamment lors de la phase de coulage.

Ainsi, selon l'exemple préféré, l'étape de remplissage peut se poursuivre avec une deuxième phase destinée à sécher la barbotine afin d'obtenir le matériau précurseur 5₁, 5₂ de la céramique comme illustré à la figure 2. On comprend que le but de cette deuxième phase est principalement de retirer la matière liquide de la barbotine, c'est-à-dire l'eau ou le solvant cité ci-dessus.

Afin de permettre au matériau précurseur 5₁, 5₂ de former une masse homogène à l'issue de la phase de séchage, ledit au moins un adjuvant de la barbotine peut comporter un liant comme, par exemple, un liant organique.

Optionnellement, le procédé peut comporter, avant la troisième étape expliquée ci-dessous, une étape de mise en épaisseur du moule 3, 13 et du matériau précurseur 5₁, 5₂ afin d'ajuster l'état de surface et l'épaisseur de l'ébauche 7₁, 7₂ en matériau précurseur.

Le procédé se poursuit avec une troisième étape destinée à retirer le moule 3, 13 pour libérer une ébauche 7₁, 7₂ en matériau précurseur 5₁, 5₂. Dans l'exemple de la figure 3, on peut voir que les ébauche 7₁, 7₂ en matériau précurseur 5₁, 5₂ forment ainsi des roues dentées avec un évidement central 8₁, 8₂.

L'étape de retrait du moule 3, 13 peut comporter une attaque sèche, une attaque humide ou un traitement thermique. Typiquement, dans le cas cité ci-dessus d'une résine photosensible du type SU-8, une attaque plasma ou un traitement thermique de quelques centaines de degrés Celsius peuvent être envisagés pour réaliser la troisième étape.

Suivant un premier mode de réalisation, le procédé se poursuit avec une quatrième étape destinée à transformer l'ébauche 7₁, 7₂ en matériau précurseur 5₁, 5₂ en composant horloger 21 en céramique puis, dans une cinquième étape, à libérer le composant horloger 21 en céramique du substrat 1.

Suivant un deuxième mode de réalisation, le procédé se poursuit avec une quatrième étape destinée à libérer l'ébauche 7₁, 7₂ en matériau précurseur 5₁, 5₂ du substrat 1 puis, dans une cinquième étape, à transformer l'ébauche 7₁, 7₂ en matériau précurseur 5₁, 5₂ en composant horloger 21 en céramique.

Quel que soit le mode de réalisation, l'étape de transformation en céramique peut, par exemple, comporter une première phase de déliantage destinée à retirer du matériau précurseur 5₁, 5₂, tout adjuvant apporté lors du procédé puis une deuxième phase de frittage. Chaque phase est principalement caractérisée par la température appliquée au matériau précurseur 5₁, 5₂. Ainsi, la température lors de la première phase peut être comprise entre 300 et 700°C alors que la température, lors de la deuxième phase, peut être comprise entre 1400 et 1700°C.

On comprend donc que si l'étape de retrait du moule 3, 13 est réalisée par traitement thermique, la première phase de déliantage peut être réalisée en même temps.

A l'issue du procédé, on obtient, avantageusement selon l'invention, un composant horloger 21, 31 à au moins un niveau, totalement monobloc en céramique polycristalline dont la précision dimensionnelle est de l'ordre de quelques microns et dont la forme peut être très variée.

Ainsi, de manière non limitative, il est possible de fabriquer un composant horloger à un niveau comme, par exemple, une roue dentée 23 illustrée à la figure 4 munie d'un évidement central 25, un spiral 41 illustré à la figure 5 muni d'une virole 43 et d'une lame 45 monoblocs, tout ou partie d'une ancre 51 illustrée à la figure 6 comme la baguette 53 et/ou les palettes 55, un coussinet 61 illustré à la figure 7 muni d'un trou 65 et d'un huilier 63, une glace 71 illustrée à la figure 8 munie d'une surface supérieure bombée, des aiguilles 81 illustrées à la figure 9, une carrure 99 ou un maillon 92 de bracelet 94 illustrés à la figure 10.

De plus, de manière non limitative, il est possible de fabriquer un composant horloger à plusieurs niveaux comme, par exemple, un mobile 31 illustré à la figure 12 muni de deux roues dentées 33, 37 monoblocs et d'un évidement central 35, tout ou partie d'une ancre 51 illustrée à la figure 6 comme la baguette 53 et/ou les palettes 55 et/ou le dard 57, un pignon 101 illustré à la figure 13 muni d'une denture de chant 103, un cadran 111 illustré à la figure 14 muni d'un guichet 113, d'un décor 115 et d'un tour d'heures 117 ou des cornes 97 munies d'évidements pour la barrette de bracelet 94, une couronne 93 ou un poussoir 95 illustrés à la figure 10.

Bien entendu, la présente invention ne se limite pas à l'exemple illustré mais est susceptible de diverses variantes et modifications qui apparaîtront à l'homme de l'art. En particulier, l'invention ne saurait se limiter à une pièce d'habillage ou même au domaine horloger. Ainsi, à titre d'exemple, rien n'empêche d'utiliser la céramique polycristalline selon l'invention pour une application dans le domaine des arts de la table, de la bijouterie ou de la joaillerie.

## Revendications

1. Procédé de fabrication d'un composant horloger (21, 31, 41, 51, 61, 71, 81, 93, 95, 94, 97, 99, 101, 111) en céramique comportant les étapes suivantes :
- former, par photolithographie sur un substrat (1), un moule (3, 13) muni d'au moins une cavité (2₁, 2₂, 12₁, 12₂) ;
- remplir ladite au moins une cavité (2₁, 2₂, 12₁, 12₂) du moule (3, 13) à l'aide d'un matériau précurseur (5₁, 5₂) d'une céramique ;
- retirer le moule (3, 13) pour libérer une ébauche (7₁, 7₂) en matériau précurseur ;
- transformer l'ébauche (7₁, 7₂) en matériau précurseur (5₁, 5₂) en composant horloger (21, 31, 41, 51, 61, 71, 81, 93, 95, 94, 97, 99, 101, 111) en céramique ;
- libérer le composant horloger (21, 31, 41, 51, 61, 71, 81, 93, 95, 94, 97, 99, 101, 111) en céramique du substrat (1).

2. Procédé de fabrication d'un composant horloger (21, 31, 41, 51, 61, 71, 81, 93, 95, 94, 97, 99, 101, 111) en céramique comportant les étapes suivantes :
- former, par photolithographie sur un substrat (1), un moule (3, 13) muni d'au moins une cavité (2₁, 2₂, 12₁, 12₂) ;
- remplir ladite au moins une cavité (2₁, 2₂, 12₁, 12₂) du moule (3, 13) à l'aide d'un matériau précurseur (5₁, 5₂) d'une céramique ;
- retirer le moule (3, 13) pour libérer une ébauche (7₁, 7₂) en matériau précurseur (5₁, 5₂) ;
- libérer l'ébauche (7₁, 7₂) en matériau précurseur (5₁, 5₂) du substrat (1) ;
- transformer l'ébauche (7₁, 7₂) en matériau précurseur (5₁, 5₂) en composant horloger (21, 31, 41, 51, 61, 71, 81, 93, 95, 94, 97, 99, 101, 111) en céramique.

3. Procédé selon la revendication 1 ou 2, **caractérisé en ce que** le moule (3, 13) est formé à partir d'une résine photosensible du type positif ou négatif.

4. Procédé selon l'une des revendications précédentes, **caractérisé en ce que** ladite au moins une cavité (21, 22, 121, 122) du moule (3, 13) comporte au moins une paroi non verticale.

5. Procédé selon l'une des revendications précédentes, **caractérisé en ce que** le moule (3, 13) comporte plusieurs cavités (2₁, 2₂, 12₁, 12₂).

6. Procédé selon la revendication précédente, **caractérisé en ce que** deux cavités (2₁, 2₂, 12₁, 12₂) de motifs différents sont formées l'une au-dessus de l'autre concentriquement pour former un composant horloger (21, 31, 41, 51, 61, 71, 81, 93, 95, 94, 97, 99, 101, 111) à plusieurs niveaux.

7. Procédé selon la revendication 5 ou 6, **caractérisé en ce que** au moins deux cavités (2₁, 2₂, 12₁, 12₂) adjacentes sont reliées par un canal pour former une plaquette avec plusieurs composants horlogers (21, 31, 41, 51, 61, 71, 81, 93, 95, 94, 97, 99, 101, 111) reliés entre eux.

8. Procédé selon l'une des revendications précédentes, **caractérisé en ce que** le substrat (1) est formé à base de silicium ou de céramique.

9. Procédé selon l'une des revendications précédentes, **caractérisé en ce que** l'étape de remplissage est réalisée par voie liquide.

10. Procédé selon la revendication précédente, **caractérisé en ce que** l'étape de remplissage comporte les phases suivantes :
- couler une barbotine dans le moule (3, 13) ;
- sécher la barbotine afin d'obtenir le matériau précurseur (5₁, 5₂) d'une céramique dans le moule (3, 13).

11. Procédé selon la revendication précédente, **caractérisé en ce que** la barbotine comporte une matière liquide, de la poudre de céramique et au moins un adjuvant destiné à faciliter le procédé.

12. Procédé selon la revendication précédente, **caractérisé en ce que** la matière liquide comporte de l'eau ou un solvant.

13. Procédé selon la revendication 11 ou 12, **caractérisé en ce que** la poudre de céramique comporte une taille de grains inférieure à 10 *µ*m.

14. Procédé selon l'une des revendications 11 à 13, **caractérisé en ce que** la poudre de céramique comporte du bore pour améliorer la tribologie du composant horloger (21, 31, 41, 51, 61, 71, 81, 93, 95, 94, 97, 99, 101, 111).

15. Procédé selon l'une des revendications 11 à 14, **caractérisé en ce que** ledit au moins un adjuvant comporte un liant permettant à l'ébauche (7₁, 7₂) en matériau précurseur (5₁, 5₂) à former une masse homogène à l'issue de la phase de séchage.

16. Procédé selon l'une des revendications 11 à 15, **caractérisé en ce que** ledit au moins un adjuvant comporte un dispersant permettant à la barbotine de former une suspension homogène lors de la phase de coulage.

17. Procédé selon l'une des revendications précédentes, **caractérisé en ce que** l'étape de retrait du moule (3, 13) comporte une attaque sèche, une attaque humide ou un traitement thermique.

18. Procédé selon l'une des revendications précédentes, **caractérisé en ce que** le procédé comporte en outre, avant l'étape de remplissage du moule (3, 13), une étape de dépôt d'une couche anti-adhérente permettant de retirer plus facilement le substrat (1).

19. Procédé selon l'une des revendications précédentes, **caractérisé en ce que** le procédé comporte en outre, après l'étape de formation du moule (3, 13), une étape de mise en épaisseur du moule (3, 13) afin d'homogénéiser son épaisseur.

20. Procédé selon l'une des revendications précédentes, **caractérisé en ce que** le procédé comporte en outre, avant l'étape de retrait du moule (3, 13), une étape de mise en épaisseur du moule (3, 13) et de l'ébauche (7₁, 7₂) en matériau précurseur (5₁, 5₂) afin d'ajuster l'état de surface et l'épaisseur de l'ébauche (7₁, 7₂) en matériau précurseur (5₁, 5₂).

21. Procédé selon l'une des revendications précédentes, **caractérisé en ce que** le composant horloger (21, 31, 41, 51, 61, 71, 81, 93, 95, 94, 97, 99, 101, 111) forme tout ou partie d'une pièce d'habillage ou d'un organe du mouvement d'une pièce d'horlogerie.
